# EUROPÄISCHE PATENTSCHRIFT

(11) **EP 1 440 771 B1**
(45) Veröffentlichungstag und Bekanntmachung des Hinweises auf die Patenterteilung: **22.10.2008**
(21) Anmeldenummer: 04100156.1
(22) Anmeldetag: 20.01.2004
(51) Int. Cl.: B25F 5/00, H01H 9/06, H03K 17/96

(54) **Steuerung einer Handwerkzeugmaschine**
Controlling device for a hand-held power tool
Dispositif de commande d'un outil portatif motorisé

(30) Priorität: 23.01.2003 DE 10302532
(43) Veröffentlichungstag der Anmeldung: 28.07.2004
(73) Patentinhaber: HILTI Aktiengesellschaft, 9494 Schaan (LI)
(72) Erfinder: Schaer, Roland, 9472, Grabs (CH); Würsch, Christoph, 9470, Werdenberg (CH); Schmitzer, Harald, 9470, Werdenberg (CH); Teixeira, Ricardo, 6800, Feldkirch (AT); Böni, Hans, 9470, Buchs (CH); Bertsch, Klaus, 6820, Frastanz (AT)
(74) Vertreter: Wildi, Roland

(56) Entgegenhaltungen:
- DE-C- 19 738 092
- US-A- 3 651 391

## Beschreibung

Die Erfindung betrifft eine Handwerkzeugmaschine, insbesondere eines Meisselhammers oder Bohrhammers mit den gattungsbildenden Merkmalen des Anspruchs 1, sowie ein Steuerverfahren mit den gattungsbildenden Merkmalen des Anspruchs 14. Eine solche Handwerkzeugmaschine und ein solches Steuerverfahren sind aus der US-A-5583386 bekannt. Handwerkzeugmaschinen erfahren bei zweckentsprechender Nutzung eine Wechselwirkung mit dem zu bearbeitenden Werkstück, wodurch auf die Handwerkzeugmaschinen stochastische Beschleunigungskräfte wirken, die zur Führung über zumindest einen Führungshandgriff über das Hand-Arm-System vom Nutzer aktiv kompensiert werden müssen.

Üblicherweise haben Handwerkzeugmaschinen einen monostabilen, bei der zweckentsprechenden Nutzung ständig vom Nutzer manuell zu betätigenden, Haupt- oder Regelschalter, welcher zumeist werkstückseitig an einem, mit einer Hand umfassbaren, Führungshandgriff angeordnet ist. Dadurch wird ergonomisch eine hinreichende Nutzungssicherheit erreicht, indem bei der Steuerung der Handwerkzeugmaschine der Führungshandgriff zumindest umfasst sein muss und somit vom Nutzer intuitiv fest gehalten wird.

Da insbesondere bei monotonen Bearbeitungsvorgängen eine ständige Betätigung des Haupt- oder Regelschalters lästig ist, sind oftmals zusätzliche Arretierungsmittel vorhanden, welche bei bestimmten Betriebsmodi mit geringeren Anforderungen für eine hinreichende Nutzungssicherheit, bspw. Meisseln, eine Arretierung des Haupt- oder Regelschalters in Arbeitsstellung gestatten sowie durch Betätigung des Haupt- oder Regelschalters intuitiv lösbar sind.

Nach der US5014793 ist der am umfassbaren Führungshandgriff werkstückseitig angeordnete Haupt- oder Regelschalter als Kraftsensor ausgebildet, welcher über einen Mikrocontroller die Handwerkzeugmaschine steuert.

Nach der EP1221359 weist eine Handwerkzeugmaschine am umfassbaren Handgriff einen Kraftsensor zur Messung des nutzerseitigen Anpressdrucks auf, um über einen vom Mikrocontroller gesteuerten Aktor am Handgriff dessen Vibrationen zu vermindern. Nach der DE4306524 wird die Handwerkzeugmaschine in Abhängigkeit vom Anpressdruck auf das Werkstück gesteuert.

Nach der DE19738092 ist bei einer Handwerkzeugmaschine am umfassbaren Führungshandgriff ausschliesslich querseitig ein vom Daumen betätigbarer Kraftsensor angeordnet, welcher über einen Mikrocontroller mit unterschiedlichen Steueralgorithmen intuitiv die Handwerkzeugmaschine steuert. Zumindest in den Steueralgorithmen, welche nicht ständig den Steuerdruck des Daumens benötigen, ist eine zur sicheren Nutzung notwendige Umfassung des Führungshandgriffs nicht ergonomisch sichergestellt.

Nach der US3651391 weist eine Handwerkzeugmaschine zum Antrieb eines Werkzeugs eine Motorsteuerung sowie einen händisch umfassbaren Handgriff mit einem, mit der Motorsteuerung verbundenen, Sensor mit einer manuell betätigbaren ersten Sensorfläche am Handgriff auf, welche der Aufrechterhaltung des Motorantriebs dient, wobei ausserhalb des Handgriffs eine mit dem Daumen betätigbare zweite Sensorfläche vorhanden ist, die zur Initialisierung des Motorantriebs dient.

Nach der US5583386 weist eine Handwerkzeugmaschine zum Antrieb eines Werkzeugs mit einem Steuermittel zur Steuerung eines Antriebsmittels sowie mit zumindest einem händisch umfassbaren Handgriff mit zumindest einem, mit dem Steuermittel verbundenen, Sensor mit einer manuell betätigbaren ersten Sensorfläche (6a), wobei eine zweite Sensorfläche vorhanden ist und beide Sensorflächen innerhalb eines händisch umfassbaren Griffbereiches umfänglich versetzt angeordnet sind. Im zugeordneten Steuerverfahren eines Steuermittels für einen Antrieb einer Handwerkzeugmaschine wird in einem ersten Schritt ein Sensorsignal eines Sensors als Steuerparameter erfasst und in einem zweiten Schritt in Abhängigkeit des Steuerparameters vom Steuermittel der Antrieb ein- und ausgeschaltet, wobei im ersten Schritt mit dem Sensor die händische Umfassung eines Griffbereiches detektiert wird.

Die Aufgabe der Erfindung besteht in der Realisierung einer Steuerung einer Handwerkzeugmaschine mit erhöhter Nutzungssicherheit.

Die Aufgabe wird durch die Merkmale der unabhängigen Ansprüche gelöst. Vorteilhafte Weiterbildungen ergeben sich aus den Unteransprüchen.

Erfindungsgemäß weist eine Handwerkzeugmaschine zum Antrieb eines Werkzeugs ein Steuermittel zur Steuerung eines Antriebsmittels sowie einen händisch umfassbaren Handgriff mit einem, mit dem Steuermittel verbundenen, Sensor mit einer manuell betätigbaren ersten Sensorfläche auf, wobei zumindest eine zweite Sensorfläche vorhanden ist und beide Sensorflächen innerhalb eines händisch umfassbaren Griffbereiches umfänglich versetzt angeordnet sind sowie der sensor als Differenzkraftsensor bezüglich des Handgriffs längs der Arbeitsrichtung ausgebildet ist.

Durch die zumindest beiden, innerhalb eines händisch umfassbaren Griffbereiches umfänglich versetzt angeordneten, Sensorflächen ist ein für eine hinreichende Nutzungssicherheit notwendiges Umfassen des Handgriffs ergonomisch vom Steuermittel detektierbar sowie der Antrieb entsprechend aktivierbar / deaktivierbar.

Vorteilhaft ist der Handgriff der Führungshandgriff und/oder ein Seitenhandgriff, wodurch jeweils für sich bzw. in Kombination eine notwendige Umfassung detektierbar ist, bspw. in Abhängigkeit vom Betriebsmodus beim Meisseln nur des Führungshandgriffs, beim Schlagbohren des Führungshandgriffs sowie des Seitenhandgriffs.

Vorteilhaft weist der Sensor einen internen Schaltschwellwert auf, wodurch auch eine zwar unvollständige, jedoch hinreichende Berührung zuverlässig detektierbar ist.

Vorteilhaft weist der Sensor eine interne Sensorschaltung mit einem logischen Ausgang auf, wodurch dieser das als Mikrocontroller mit Leistungsschalter ausgebildete Steuermittel digital ansteuern kann.

Vorteilhaft weisen zumindest zwei Sensoren logische Ausgänge auf, welche miteinander logisch AND verknüpft sind, wodurch aus den einzelnen Sensorwerten ein Sicherheitssignal bezüglich einer Mindestumfassung des Handgriffs generierbar ist. Zudem wird ein, bspw. durch einseitige Verunreinigungen des Handgriffs erzeugtes, Fehlsignal zuverlässig unterdrückt.

Vorteilhaft ist der Sensor als Polymer-Folienkraftsensor zwischen einer werkzeugseitigen und einer nutzerseitigen Grifffläche ausgebildet, wodurch die bei der Umfassung des Handgriffs notwendig entstehende Handkraft zuverlässig als Umfassungssignal detektierbar ist.

Vorteilhaft ist der Differenzkraftsensor aus zwei zueinander entgegengesetzt orientierten und verschalteten Kraftsensoren ausgebildet, bspw. aus Piezosensoren, welche jeweils gegen einen mit der Handwerkzeugmaschine steif verbundenen Kern des Handgriffs messen, wodurch zumindest teilweise vorhandene Kraftsensoren zusätzlich für den Differenzkraftsensor zum Detektieren des Umfassungssignals benutzbar sind.

Vorteilhaft weisen die beiden Kraftsensoren jeweils eine interne Sensorschaltung mit einem zumindest quasikontinuierlichen Ausgang auf, wodurch die beiden gemessenen Absolutkraftwerte der werkzeugseitigen und der nutzerseitigen Grifffläche als solche und in geeigneter Funktion, bspw. als Differenz und Summe, dem Steuermittel zur Steuerung verfügbar sind.

In einer nicht erfindungsgemäßen Ausführungsform ist der Sensor ein Berühungssensor mit als Berührungskontaktflächen ausgebildeten Sensorflächen, welcher nach dem Prinzip eines hochohmigen Widerstandssensors oder kapazitiven Sensors mit zwei voneinander isolierten Berührungskontaktflächen funktioniert, wodurch eine Berührung mit der Hand oder einem Handschutz, der beide Berührungskontaktflächen überbrückt, zuverlässig als Umfassungssignal detektierbar ist.

Vorteilhaft sind die Berührungskontaktflächen als leitfähige Bleche ausgebildet, welche in ein als Isolator wirkendes Griffmaterial eingebettet sind, wodurch ein auch im rauhen Umfeld des Baugewerbes zuverlässiger Sensor realisierbar ist.

Vorteilhaft sind mehr als zwei Sensorflächen innerhalb eines händisch umfassbaren Griffbereiches umfänglich versetzt angeordnet, wodurch ein teilweises, umfängliches Umfassen des Handgriffs detektierbar ist.

Vorteilhaft sind von mehreren Sensorflächen zumindest teilweise umfänglich, paarweise alternierende Sensorflächen miteinander verbunden, wodurch zwei teilweise umfänglich ineinander verschachtelte Berührungskontaktflächen ausgebildet sind, die flächige Strukturen ausbilden, bspw. Kämme, Serpentinen oder Spiralen.

Vorteilhaft sind von mehreren Sensorflächen jeweils genau zwei zumindest zwei Sensoren zugeordnet, wodurch das Umfassen des Handgriffs segmentweise zuordenbar detektierbar ist.

Im zugeordneten Steuerverfahren eines Steuermittels für einen Antrieb einer Handwerkzeugmaschine wird in einem ersten Schritt ein Sensorsignal eines Sensors als Steuerparameter erfasst und in einem zweiten Schritt in Abhängigkeit des Steuerparameters vom Steuermittel der Antrieb gesteuert, wobei im ersten Schritt mit dem Sensor die händische Umfassung eines Griffbereiches detektiert wird und im zweiten Schritt bei Überschreiten einer Mindestdifferenzkraft und somit detektierter hinreichender Umfassung des Handgriffs eine Sensorsteuerung für den Antrieb aktiviert bzw. anderenfalls deaktiviert wird.

Durch die Detektion der händischen Umfassung eines Griffbereiches ist für das Steuermittel sicher erkennbar, ob die Handwerkzeugmaschine vom Nutzer zur zweckentsprechenden Verwendung richtig gehandhabt oder der Sensor nur anderweitig aktiviert wird, bspw. beim Transport der Handwerkzeugmaschine oder einer Ablage auf dem Sensor. Bei einer somit sichergestellten händischen Umfassung eines Handgriffs ist die physiologische Voraussetzung dafür gegeben, auf vom Antrieb und/oder der Wechselwirkung des Werkzeugs mit dem Werkstück hervorgerufene Beschleunigungen des Gehäuses der Handwerkzeugmaschine intuitiv hinreichend schnell entsprechend zu reagieren. Insbesondere ist durch eine derartige Detektion die unmittelbare Aktivierung des Antriebs der Handwerkzeugmaschine oder die Bereitschaft für die Aktivierung des Antriebs über eine Sensorsteuerung in sicherer Weise direkt möglich, wodurch diesbezügliche manuell betätigbare Antriebsschalter entfallen können.

Bei im zweiten Schritt aktiverter Sensorsteuerung wird weiter vorteilhaft in einem dritten Schritt bei Überschreiten einer nutzerseitigen Mindestsummenkraft der Antrieb aktiviert, in Abhängigkeit dieser Kraft die Antriebsleistung geregelt und bei Überschreiten einer werkzeugseitigen Mindestsummenkraft der Antrieb deaktiviert, wodurch eine intuitive Leistungssteuerung der Handwerkzeugmaschine erfolgt.

Vorteilhaft ist im zweiten Schritt ein vorwählbarer Betriebsmodus ein weiterer Steuerparameter, wodurch weiter vorteilhaft beim Meisseln nur eine Mindestdifferenzkraft des Führungshandgriffs für eine aktivierte Sensorsteuerung notwendig ist, beim Schlagbohren hingegen jeweils eine Mindestdifferenzkraft des Führungshandgriffs und des Seitenhandgriffs.

Vorteilhaft ist im zweiten Schritt die Zeit ein weiterer Steuerparameter, wodurch weiter vorteilhaft durch kurzzeitigen Andruck bzw. Wegzug der Handwerkzeugmaschine der Antrieb aktiviert bzw. deaktiviert wird.

Vorteilhaft wird im zweiten Schritt bei Überschreiten einer werkzeugseitigen Mindestsummenkraft über eine gewisse Zeitspanne von länger 1 s ein Transport am Handgriff detektiert und die Aktivierung der Sensorsteuerung für eine gewisse Zeitspanne von länger 5 s unterbunden.

Die Erfindung wird bezüglich eines vorteilhaften Ausführungsbeispiels näher erläutert mit:
- Fig. 1a: als Handwerkzeugmaschine in Seitenansicht;
- Fig. 1b: als Rückansicht zur Fig. 1a, teilweise aufgeschnitten
- Fig. 2a,: 2b, 2c als Varianten von Berührungskontaktflächen
- Fig. 3: als Einzelheit des Sensors
- Fig. 4a,: 4b als Varianten einer Einzelheit der erfindungsgemäßen Handwerkzeugmaschine
- Fig. 5: als Variante einer Einzelheit des Sensors

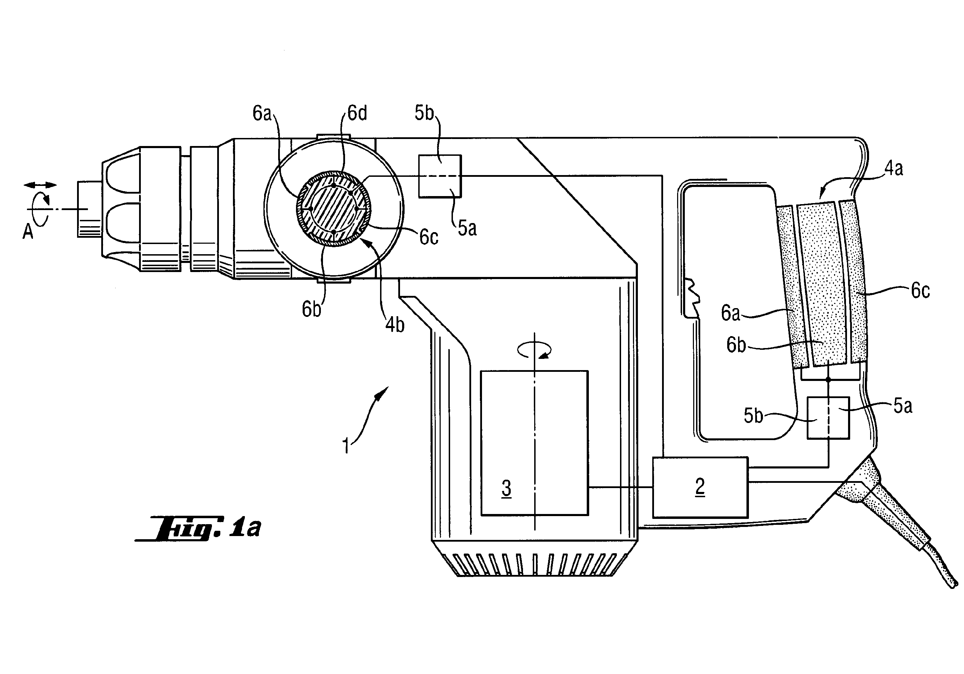

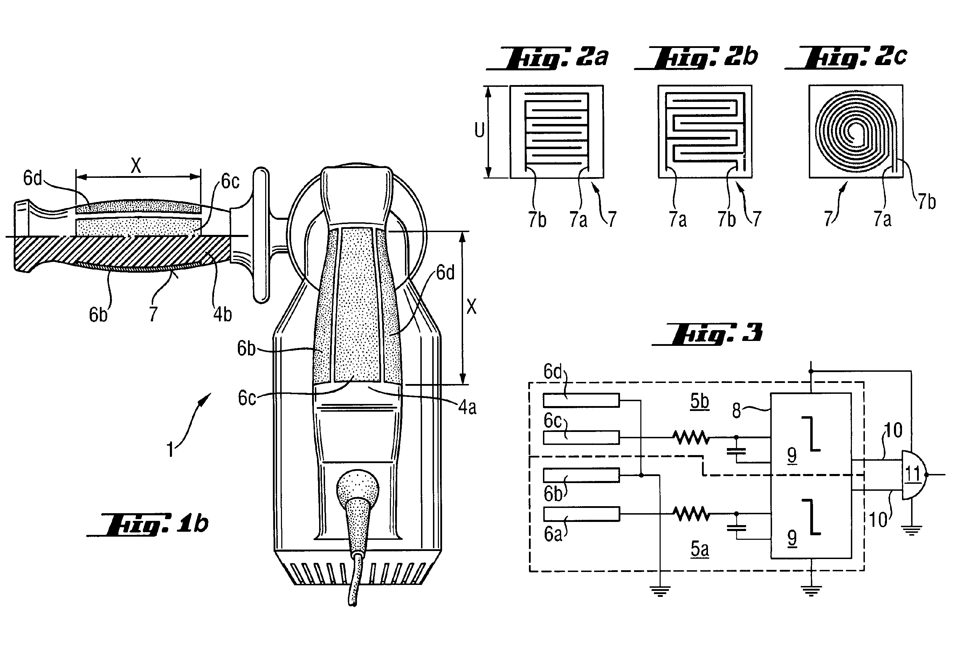

Nach Fig. 1 weist eine Handwerkzeugmaschine 1 zum drehenden und schlagenden Antrieb eines nicht dargestellten Werkzeugs längs einer Arbeitsrichtung A ein Steuermittel 2 zur Steuerung eines Antriebsmittels 3 in Form eines Elektromotors auf. Zwei händisch umfassbare Handgriffe 4a, 4b in Form eines Führungshandgriffs und eines Seitenhandgriffs weisen jeweils zwei mit dem Steuermittel 2 verbundene Sensoren 5a, 5b mit vier manuell betätigbaren Sensorflächen 6a, 6b, 6c, 6d auf. Diese sind innerhalb eines händisch umfassbaren Griffbereiches X umfänglich versetzt angeordnet. In einer nicht erfindungsgemäßen Ausführungsform sind die Sensoren 5a, 5b als Berühungssensoren mit als Berührungskontaktflächen 7 ausgebildeten Sensorflächen 6a, 6b, 6c, 6d ausgebildet. Die Berührungskontaktflächen 7 sind als leitfähige Bleche ausgebildet, welche in die Handgriffe 4a, 4b aus Plastik eingebettet sind.

Die unterschiedlichen Varianten von Berührungskontaktflächen 7 bilden bei einer über den Umfang U umfänglich abgewickelten Darstellung jeweils flächige Strukturen aus, nach Fig. 2a Kämme, nach Fig. 2b Serpentinen oder nach Fig. 2c Spiralen. Dabei sind jeweils umfänglich paarweise alternierende Berührungskontaktflächen 7a, 7b miteinander verbunden.

Nach Fig. 3 bilden die paarweise gegenüberliegenden Sensorflächen 6a, 6c sowie 6b, 6d jeweils mit einem Teil einer integrierten Sensorschaltung 8 zwei umfänglich um 90° versetzte Sensoren 5a, 5b. Diese integrierte Sensorschaltung 8 weist jeweils einen Schwellwertschalter 9 und einem logischen Ausgang 10 auf. Die beiden Sensoren 5a, 5b zugeordneten logischen Ausgänge 10 sind in einem NAND-Schaltkreis 11 miteinander logisch AND verknüpft.

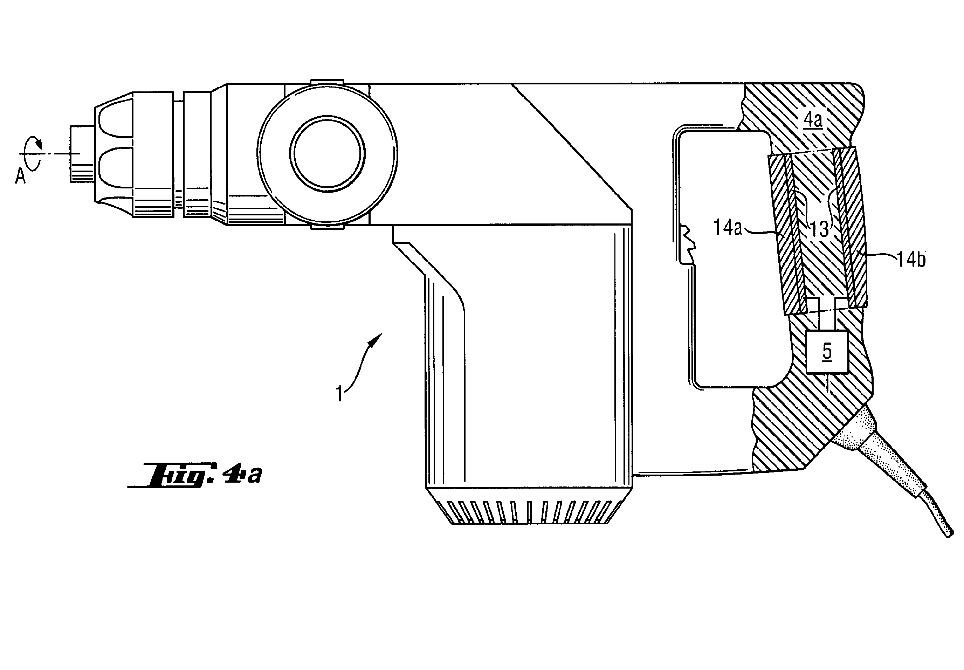

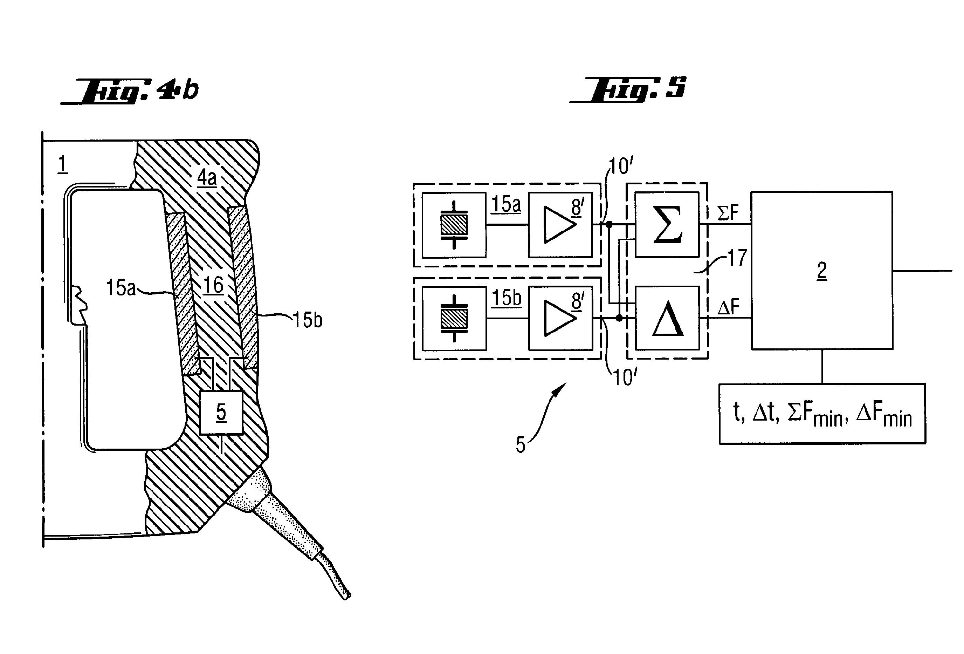

Nach Fig. 4a ist bei einer erfindungsgemäßen Variante des Handgriffs 4a der Sensor 5 als längs der Arbeitsrichtung A sensibler Differenzkraftsensor 13 in Form eines Polymer-Folienkraftsensors ausgebildet, indem er zwischen einer werkzeugseitigen Grifffläche 14a und einer nutzerseitigen Grifffläche 14b angeordnet ist. Nach Fig. 4b ist bei einer weiteren Variante der Differenzkraftsensor 13 aus zwei einzelnen, zueinander entgegengesetzt orientierten und verschalteten, Kraftsensoren 15a, 15b in Form zweier Piezosensoren ausgebildet, welche jeweils gegen einen mit der Handwerkzeugmaschine 1 steif verbundenen Kern 16 des Handgriffs 4a sensibel sind.

Nach Fig. 5 weisen in einer Variante des Sensors 5 die beiden Kraftsensoren 15a, 15b jeweils eine interne Sensorschaltung 8' mit einem zumindest quasikontinuierlichen Ausgang 10' auf, welche mit einem Summen/Differenz-Schaltkreis 17 zur Ermittlung der Differenzkraft ΔF und der Summenkraft ΣF verbunden sind, die in dem Steuermittel 2 mit einer Zeit t, einer Zeitspanne Δt, einer Mindestdifferenzkraft ΔFₘᵢₙ bzw. einer Mindestsummenkraft ΣFₘᵢₙ in Relation zueinander gebracht werden.

## Patentansprüche

1. Handwerkzeugmaschine zum Antrieb eines Werkzeugs mit einem Steuermittel (2) zur Steuerung eines Antriebsmittels (3) sowie mit zumindest einem händisch umfassbaren Handgriff (4a) mit zumindest einem, mit dem Steuermittel (2) verbundenen, Sensor (5a) mit einer manuell betätigbaren ersten Sensorfläche (6a), wobei zumindest eine zweite Sensorfläche (6b) vorhanden ist und beide Sensorflächen (6a, 6b) innerhalb eines händisch umfassbaren Griffbereiches (X) umfänglich versetzt angeordnet sind, **dadurch gekennzeichnet, dass** der Sensor (5a) als längs der Arbeitsrichtung (A) sensibler Differenzkraftsensor (13) ausgebildet ist.

2. Handwerkzeugmaschine nach Anspruch 1, **dadurch gekennzeichnet, dass** der Handgriff (4a, 4b) als Führungshandgriff und/oder als Seitenhandgriff ausgebildet ist.

3. Handwerkzeugmaschine nach Anspruch 1 oder 2, **dadurch gekennzeichnet, dass** der Sensor (5a) einen internen Schwellwertschalter (9) aufweist.

4. Handwerkzeugmaschine nach einem der Ansprüche 1 bis 3, **dadurch gekennzeichnet, dass** der Sensor (5a) eine interne Sensorschaltung (8) mit einem logischen Ausgang (10) aufweist.

5. Handwerkzeugmaschine nach Anspruch 4, **dadurch gekennzeichnet, dass** zumindest zwei Sensoren (5a, 5b) logische Ausgänge (10) aufweisen, welche miteinander logisch AND verknüpft sind.

6. Handwerkzeugmaschine nach einem der vorherigen Ansprüche, **dadurch gekennzeichnet, dass** der Differenzkaftsensor (13) zwischen einer werkzeugseitigen und einer nutzerseitigen Grifffläche (14a, 14b) des Handgriffs (4a) ausgebildet ist.

7. Handwerkzeugmaschine nach Anspruch 6, **dadurch gekennzeichnet, dass** der Differenzkraftsensor (13) aus zwei zueinander entgegengesetzt orientierten und verschalteten Kraftsensoren (15a, 15b) ausgebildet ist, welche optional jeweils gegen einen steifen Kern (16) des Handgriffs (4a) messen.

8. Handwerkzeugmaschine nach Anspruch 6, **dadurch gekennzeichnet, dass** die beiden Kraftsensoren (15a, 15b) jeweils eine interne Sensorschaltung (8') mit einem zumindest quasikontinuierlichen Ausgang (10') aufweisen.

9. Handwerkzeugmaschine nach Anspruch 1-8, **dadurch gekennzeichnet, dass** mehr als zwei Sensorflächen (6a, 6b, 6c) innerhalb eines händisch umfassbaren Griffbereiches (X) umfänglich versetzt angeordnet sind.

10. Handwerkzeugmaschine nach Anspruch 9, **dadurch gekennzeichnet, dass** zumindest zwei, teilweise umfänglich paarweise alternierende, Sensorflächen (6b-6d) miteinander verbunden sind.

11. Handwerkzeugmaschine nach Anspruch 9 oder 10, **dadurch gekennzeichnet, dass** jeweils genau zwei Sensorflächen (6a-6c, 6b-6d) zumindest zwei Sensoren (5a, 5b) zugeordnet sind.

12. Steuerverfahren eines Steuermittels (2) für ein Antriebsmittel (3) einer Handwerkzeugmaschine (1), wobei in einem ersten Schritt ein Sensorsignal eines Sensors (5a) als Steuerparameter erfasst wird und in einem zweiten Schritt in Abhängigkeit des Steuerparameters vom Steuermittel (2) das Antriebsmittel (3) gesteuert wird, wobei im ersten Schritt mit dem Sensor (5a) die händische Umfassung eines Griffbereiches (X) detektiert wird, **dadurch gekennzeichnet, dass** im zweiten Schritt bei Überschreiten einer Mindestdifferenzkraft (ΔFₘᵢₙ) und somit detektierter hinreichender Umfassung des Handgriffs (4a) eine Sensorsteuerung für das Antriebsmittel (3) aktiviert bzw. anderenfalls deaktiviert wird.

13. Steuerverfahren nach Anspruch 12, **dadurch gekennzeichnet, dass** bei im zweiten Schritt aktiverter Sensorsteuerung in einem dritten Schritt bei Überschreiten einer nutzerseitigen Mindestsummenkraft (ΣFₘᵢₙ) der Antrieb aktiviert wird, in Abhängigkeit dieser Kraft die Antriebsleistung geregelt und bei Überschreiten einer werkzeugseitigen Mindestsummenkraft (-ΣFₘᵢₙ) der Antrieb deaktiviert wird.

14. Steuerverfahren nach Anspruch 12 oder 13, **dadurch gekennzeichnet, dass** im zweiten Schritt ein vorwählbarer Betriebsmodus ein weiterer Steuerparameter ist, optional indem beim Meisseln nur eine Mindestdifferenzkraft (ΔFₘᵢₙ) des Führungshandgriffs (4a) für eine aktivierte Sensorsteuerung notwendig ist, beim Schlagbohren hingegen jeweils eine Mindestdifferenzkraft (ΔFₘᵢₙ) des Führungshandgriffs (4a) und des Seitenhandgriffs (4b).

15. Steuerverfahren nach einem der Ansprüche 12 bis 14, **dadurch gekennzeichnet, dass** im zweiten Schritt die Zeit (t) ein weiterer Steuerparameter ist, optional indem durch kurzzeitigen Andruck bzw. Wegzug der Handwerkzeugmaschine (1) der Antrieb aktiviert bzw. deaktiviert wird.

16. Steuerverfahren nach einem der Ansprüche 12 bis 14, **dadurch gekennzeichnet, dass** im zweiten Schritt bei Überschreiten einer werkzeugseitigen Mindestsummenkraft (-ΣFₘᵢₙ) über eine erste vordefinierte Zeitspanne (Δt) die Aktivierung der Sensorsteuerung für eine zweite vordefinierte Zeitspanne (Δt) unterbunden wird.

## Claims

1. Manual machine tool for the operation of a tool with a means of control (2) for controlling a means of drive (3) and also with at least one manually grippable handle (4a) with at least one sensor (5a) linked with the means of control (2) with a manually actuable first sensor surface (6a), with at least a second sensor surface (6b) being present and both sensor surfaces (6a, 6b) being arranged extensively movable within a manually encompassable handle area (X), **characterised by** the fact that the sensor (5a) is formed as difference sensor (13) sensitive along the working direction (A).

2. Manual machine tool according to claim 1, **characterised by** the fact that the handle (4a, 4b) is formed as a guide handle and/or as a side handle.

3. Manual machine tool according to claim 1or 2, **characterised by** the fact that the sensor (5a) exhibits an internal threshold value switch (9).

4. Manual machine tool according to one of the claims 1 to 3, **characterised by** the fact that the sensor (5a) exhibits an internal sensor switching (8) with a logical output (10).

5. Manual machine tool according to claim 4, **characterised by** the fact that at least two sensors (5a, 5b) exhibit logical outputs (10), which are connected with each other logically AND.

6. Manual machine tool according to one of the preceding claims, **characterised by** the fact that the difference force sensor (13) is formed between a gripping surface on the tool side and one on the user side (14a, 14b) of the handle (4a).

7. Manual machine tool according to claim 6, **characterised by** the fact that the difference force sensor (13) is formed of two oppositely orientated and switched force sensors (15a, 15b), which optionally measure against a rigid core (16) of the handle (4a).

8. Manual machine tool according to claim 6, **characterised by** the fact that the two force sensors (15a, 15b) in each case exhibit an internal sensor switching (8') with an at least quasi continuous output (10).

9. Manual machine tool according to claims 1-8, **characterised by** the fact that more than two sensor surfaces (6a, 6b, 6c) are fitted distributed within an encompassable handle area (X).

10. Manual machine tool according to claim 9, **characterised by** the fact that at least two sensor surfaces (6b-6d), partly alternating comprehensively in pairs, are connected with each other.

11. Manual machine tool according to claim 9 or 10, **characterised by** the fact that precisely two sensor surfaces (6a-6c, 6b-6d) are allocated to at least two sensors (5a, 5b).

12. Control procedure of a means of control (2) for a means of drive (3) of a manual machine tool (1), with which in a first step a sensor signal of a sensor (5a) is captured as control parameter and in a second step depending on the control parameter from the means of control (2) the means of drive (3) is controlled, whereby in the first step with the sensor(5a) the manual encompassment of a handle area (X) is detected, **characterised by** the fact that in the second step on the exceeding of a minimum difference force (ΔFₘᵢₙ) and therewith detected sufficient encompassment of the handle (4a) a sensor control for the means of drive is activated or in another case deactivated.

13. Control procedure according to claim 12, **characterised by** the fact that, with sensor control activated in the second step, in a third step with exceeding a minimum total power (ΣFₘᵢₙ) on the user side the drive is activated, the drive performance is regulated depending on this force and with exceeding a minimum total force (-ΣFₘᵢₙ) on the tool side the drive is deactivated.

14. Control procedure according to claim 12 or 13, **characterised by** the fact that in the second step a preselectable operating mode is a further control parameter, optional in that with carving only one minimum difference force (ΔFₘᵢₙ) of the guiding handle (4a) is necessary for an activated sensor control, with percussion drilling on the other hand there is in each case a minimum difference force (ΔFₘᵢₙ) of the guiding handle (4a) and of the side handle (4b).

15. Control procedure according to one of the claims 12 to 14, **characterised by** the fact that in the second step the time (t) is a further control parameter, optional in that by short time pressure or pulling away of the manual machine tool (1) the drive is activated or deactivated.

16. Control procedure according to one of the claims 12 to 14, **characterised by** the fact that in the second step on exceeding a minimum total force on the tool side (-ΣFₘᵢₙ) over a first predefined time span (Δt) the activation of the sensor control for a second predefined time span (Δt) is prevented.

## Revendications

1. Appareil portatif pour l'entraînement d'un outil, comprenant un moyen de commande (2) pour commander un moyen d'entraînement (3) et comprenant au moins une poignée enserrable manuellement (4a) associée à au moins un capteur (5a) relié au moyen de commande (2) et muni d'une première surface de capteur à actionnement manuel (6a), au moins une seconde surface de capteur (6b) étant prévue et les deux surfaces de capteur (6a, 6b) étant disposées avec un décalage circonférentiel à l'intérieur d'une zone de préhension enserrable manuellement (X), **caractérisé en ce que** le capteur (5a) est conformé en capteur de force différentielle (13) sensible dans le sens de la direction de travail (A).

2. Appareil portatif selon la revendication 1, **caractérisé en ce que** la poignée (4a, 4b) est conformée en poignée de guidage et/ou en poignée latérale.

3. Appareil portatif selon la revendication 1 ou 2, **caractérisé en ce que** le capteur (5a) comporte un commutateur interne de valeur de seuil (9).

4. Appareil portatif selon une des revendications 1 à 3, **caractérisé en ce que** le capteur (5a) comporte un circuit de capteur interne (8) avec une sortie logique (10).

5. Appareil portatif selon la revendication 4, **caractérisé en ce qu'**au moins deux capteurs (5a, 5b) comportent des sorties logiques (10) qui sont interconnectées par une liaison logique ET.

6. Appareil portatif selon une des revendications précédentes, **caractérisé en ce que** le capteur de force différentielle (13) est disposé entre des surfaces de préhension côté outil et côté utilisateur (14a, 14b) de la poignée (4a).

7. Appareil portatif selon la revendication 6, **caractérisé en ce que** le capteur de force différentielle (13) est constitué de deux capteurs de force (15a, 15b) orientés et câblés à l'opposé l'un de l'autre qui, optionnellement, agissent chacun contre un noyau rigide (16) de la poignée (4a).

8. Appareil portatif selon la revendication 6, **caractérisé en ce que** les deux capteurs de force (15a, 15b) comportent chacun un circuit de capteur interne (8') avec une sortie au moins quasi continue (10').

9. Appareil portatif selon les revendications 1 à 8, **caractérisé en ce que** plus de deux surfaces de capteur (6a, 6b, 6c) sont disposées avec un décalage circonférentiel à l'intérieur d'une zone de préhension enserrable manuellement (X).

10. Appareil portatif selon la revendication 9, **caractérisé en ce qu'**au moins deux surfaces de capteur (6b-6d) alternées par paires sur une partie de la circonférence sont reliées entre elles.

11. Appareil portatif selon la revendication 9 ou 10, **caractérisé en ce qu'**à exactement deux surfaces latérales (6a-6c, 6b-6d) sont associés au moins deux capteurs (5a, 5b).

12. Procédé de commande d'un moyen de commande (2) pour un moyen d'entraînement (3) d'un appareil portatif (1), dans une première étape un signal de capteur d'un capteur (5a) étant détecté en tant que paramètre de commande et, dans une deuxième étape, le moyen d'entraînement (3) étant commandé par le moyen de commande (2) en fonction du paramètre de commande, dans la première étape l'enserrement manuel d'une zone de préhension (X) étant détecté par le capteur (5a), **caractérisé en ce que**, dans la deuxième étape, en cas de dépassement d'une force différentielle minimale (ΔFₘᵢₙ) et donc en cas d'enserrement suffisant détecté de la poignée (4a), une commande de capteur pour le moyen d'entraînement (3) est activée, respectivement sinon désactivée.

13. Procédé de commande selon la revendication 12, **caractérisé en ce que**, en cas d'activation de la commande de capteur dans la deuxième étape, l'entraînement est activé dans une troisième étape en cas de dépassement d'une force cumulée minimale côté utilisateur (ΣFₘᵢₙ), la puissance d'entraînement est réglée en fonction de cette force et, en cas de dépassement d'une force cumulée minimale côté outil (ΣFₘᵢₙ), l'entraînement est désactivé.

14. Procédé de commande selon la revendication 12 ou 13, **caractérisé en ce que**, dans la deuxième étape, un mode de fonctionnement présélectionnable constitue un paramètre de commande supplémentaire, optionnellement du fait que, lors du burinage, une force différentielle minimale (ΔFₘᵢₙ) de la seule poignée de guidage (4a) est requise pour activer la commande de capteur alors que, lors du forage à percussion, une force différentielle minimale (ΔFₘᵢₙ) de la poignée de guidage (4a) et de la poignée latérale (4b) est requise.

15. Procédé de commande selon une des revendications 12 à 14, **caractérisé en ce que**, dans la deuxième étape, le temps (t) constitue un paramètre de commande supplémentaire, optionnellement du fait qu'en cas d'application, respectivement de retrait bref de l'appareil portatif (1), le moyen d'entraînement est activé, respectivement désactivé.

16. Procédé de commande selon une des revendications 12 à 14, **caractérisé en ce que**, dans la deuxième étape, en cas de dépassement d'une force cumulée minimale côté outil (-ΣFₘᵢₙ) pendant une première durée prédéfinie (Δt), l'activation de la commande de capteur pour une deuxième durée prédéterminé (Δt) est empêchée.
